# EUROPEAN PATENT APPLICATION

(11) **EP 4 848 336 A1**
(43) Date of publication of application: **02.12.2026**
(21) Application number: 25754534.3
(22) Date of filing: 17.02.2025
(51) Int. Cl.: H01L 21/78

(54) **SEMICONDUCTOR DEVICE, MANUFACTURING METHOD, INTEGRATED CIRCUIT, AND ELECTRONIC DEVICE**

(30) Priority: 18.02.2024 CN 202410181713
(71) Applicant: Huawei Technologies Co., Ltd., Shenzhen, Guangdong 518129 (CN)
(72) Inventor: QIN, Qing, Shenzhen, Guangdong 518129 (CN); KU, Shaw Hung, Shenzhen, Guangdong 518129 (CN)
(74) Representative: Thun, Clemens
(86) International application number: PCT/CN2025/077584
(87) International publication number: WO 2025/171810

(57) **Abstract**

A semiconductor device, a fabrication method, an integrated circuit, and an electronic device are provided, to reduce a dielectric capacitance of the semiconductor device. The semiconductor device includes a channel layer, a dielectric layer above the channel layer, a source region and a drain region respectively located on two opposite sides of the channel layer and the dielectric layer, and a first metal gate structure. The dielectric layer includes an annular first dielectric region and second dielectric regions respectively located on two opposite sides of the first dielectric region. The second dielectric region has a cavity in contact with the first dielectric region, and the first metal gate structure is enclosed in the first dielectric region. The cavity in contact with the first dielectric region is disposed in the second dielectric region, so that an overall dielectric constant of the second dielectric region can be reduced by using the low dielectric constant of air in the cavity, thereby reducing a dielectric capacitance of the second dielectric region, reducing an RC signal delay between the first metal gate structure and the source/drain region, and improving switching performance of the semiconductor device.

## Description

### CROSS-REFERENCE TO RELATED APPLICATIONS

This application claims priority to Chinese Patent Application No. 202410181713.6, filed with the China National Intellectual Property Administration on February 18, 2024, and entitled "SEMICONDUCTOR DEVICE, FABRICATION METHOD, INTEGRATED CIRCUIT, AND ELECTRONIC DEVICE", which is incorporated herein by reference in its entirety.

### TECHNICAL FIELD

This application relates to the field of semiconductor technologies, and in particular, to a semiconductor device, a fabrication method, an integrated circuit, and an electronic device.

### BACKGROUND

With continuous development of semiconductor technologies, fabrication processes of semiconductor devices are becoming increasingly advanced. At present, the semiconductor device has been fabricated at micrometer and nanometer scales, and will be further fabricated at a sub-nanometer scale in the future. This means that a size of a transistor in the future will be smaller than that of an existing transistor, and more transistors will be integrated on a same chip (which may also be referred to as an integrated circuit). An integration level of the chip will continue to increase, and the chip will provide increasingly powerful integrated functions.

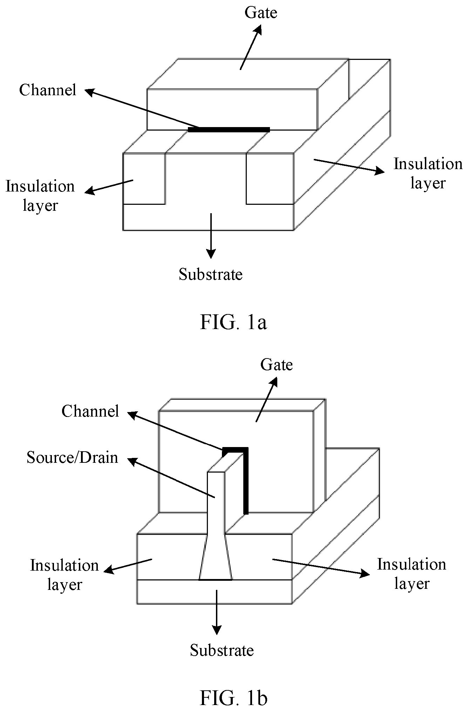

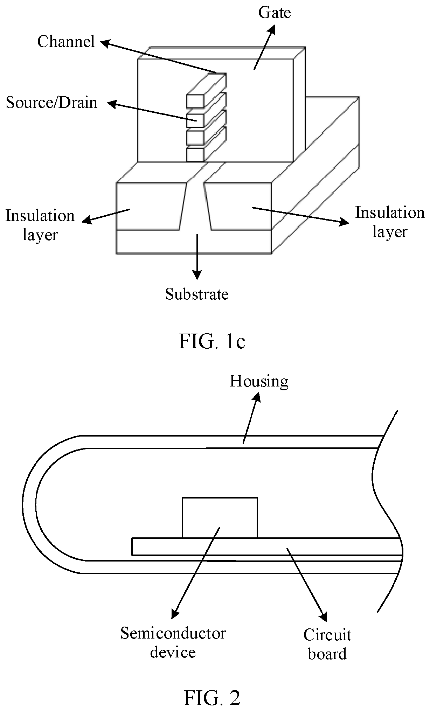

However, as the size of the transistor is reduced, a short channel effect (short channel effect, SCE) of the transistor becomes increasingly obvious. To suppress the SCE, a control capability of a gate needs to be improved. A conventional transistor uses a planar architecture, which is also referred to as a planar field-effect transistor (planar field-effect transistor, PFET), as shown in FIG. 1a. A channel of the PFET lies flat below a bottom surface of the gate, and a contact area between the gate and the channel is relatively small. As a result, an effect of electrostatic control from the gate to the channel is not ideal. Based on this, a fin field-effect transistor (FinFET) emerges, as shown in FIG. 1b. Compared with that of the PFET, a gate of the FinFET surrounds three sides of a channel, so that a contact area between the gate and the channel is greatly increased, and electrostatic control from the gate to the channel is relatively improved. However, as a size of the transistor is reduced to be less than 7 nm, an SCE of the FinFET is aggravated, and electrostatic control of the FinFET is insufficient to suppress the aggravated SCE. This drives the transistor to transform from a tri-gate architecture to a gate-all-around architecture. Therefore, a gate-all-around field-effect transistor (gate-all-around FET, GAAFET) emerges, as shown in FIG. 1c. A gate of the GAAFET surrounds four sides of a channel, so that a contact area between the gate and the channel is further increased, thereby providing a better electrostatic control characteristic than that of the FinFET. However, a mainstream GAAFET currently suffers from a large dielectric capacitance. A larger dielectric capacitance between the gate and a source/drain indicates a longer signal transmission delay between the gate and the source/drain, which is more unfavorable to improving switching performance of the GAAFET.

In conclusion, reducing a dielectric capacitance of the semiconductor device is an urgent technical problem to be resolved in the GAAFET field.

### SUMMARY

This application provides a semiconductor device, a fabrication method, an integrated circuit, and an electronic device, to reduce a dielectric capacitance of the semiconductor device.

According to a first aspect, this application provides a semiconductor device, including a channel layer, a dielectric layer above the channel layer, a source region and a drain region respectively located on two opposite sides of the channel layer and the dielectric layer, and a first metal gate structure. The dielectric layer includes an annular first dielectric region and second dielectric regions respectively located on two opposite sides of the first dielectric region, the second dielectric region has a cavity in contact with the first dielectric region, and the first metal gate structure is enclosed in the first dielectric region.

The foregoing semiconductor device is used, and the cavity in contact with the first dielectric region is disposed in the second dielectric region, so that an overall dielectric constant of the second dielectric region can be reduced by using the low dielectric constant of air in the cavity, thereby reducing a dielectric capacitance of the second dielectric region, reducing an RC signal delay between the first metal gate structure and the source/drain region, and improving switching performance of the semiconductor device.

In a possible design, a dielectric constant of the first dielectric region is higher than a dielectric constant of the second dielectric region. For example, the first dielectric region is made of a high dielectric material, and the second dielectric region is made of a low dielectric material.

According to the foregoing design, the high dielectric material is disposed around the first metal gate structure, to replace a gate oxide layer, increase a thickness of the gate oxide layer, and suppress a tunneling leakage current generated by the first metal gate structure. In addition, the low dielectric material is disposed between the high dielectric material and the source region or the drain region, so that a dielectric capacitance can be reduced by using a relatively small dielectric constant of the low dielectric material, the RC signal delay can be reduced, and an operating frequency of the semiconductor device can be increased.

In a possible design, the channel layer is in a dumbbell shape or a concave shape. For example, when there are a plurality of channel layers, a channel layer at an edge may be in a concave shape, and a channel layer in the middle is in a dumbbell shape.

According to the foregoing design, based on a negative correlation between a resistance and a thickness, a larger thickness of a dumbbell end or a protruding part of the channel layer indicates a smaller resistance of the channel layer and a smaller R parameter of the RC signal, so that the RC signal delay between the first metal gate structure and the source region or the drain region is easier to be reduced.

In a further possible design, a thickness of the second dielectric region is less than a thickness of a dumbbell end of a dumbbell-shaped channel layer, or less than a thickness of a protruding part of a concave-shaped channel layer. For example, the thickness of the second dielectric region may be 1/3, 1/4, or less of the thickness of the dumbbell end or the thickness of the protruding part.

According to the foregoing design, based on a positive correlation between a dielectric capacitance and a thickness, a smaller thickness of the second dielectric region indicates a smaller dielectric capacitance of the second dielectric region and a smaller C parameter of the RC signal, so that the RC signal delay between the first metal gate structure and the source region or the drain region is easier to be reduced. In addition, a smaller thickness of the second dielectric region indicates a smaller area of the second dielectric region and fewer breakdown points in the second dielectric region. Therefore, a breakdown probability from the first metal gate structure to the source region or the drain region can also be reduced.

In a further possible design, the first dielectric region is located above a dumbbell shaft of the dumbbell-shaped channel layer or a concave part of the concave-shaped channel layer, and the second dielectric region is located above the dumbbell end of the dumbbell-shaped channel layer or the protruding part of the concave-shaped channel layer.

According to the foregoing design, a middle position of the channel layer may be etched, and then a first dielectric material is filled in a circumferential direction of an etched hole, to obtain the first dielectric layer. This fabrication manner is relatively simple, and can reduce fabrication difficulty.

In a possible design, the cavity is enclosed between the first dielectric region, the second dielectric region, and the source region; or between the first dielectric region, the second dielectric region, and the drain region.

According to the foregoing design, the cavity penetrates the second dielectric region in a vertical direction of a stacking direction, and the cavity has a relatively large length and includes more air. This can improve an effect of reducing the overall dielectric constant of the second dielectric region.

In a possible design, the semiconductor device includes a substrate, N+1 channel layers, N dielectric layers, and N first metal gate structures, the N+1 channel layers and the N dielectric layers are alternately stacked on the substrate, and the N first metal gate structures are enclosed in first dielectric regions of the N dielectric layers in a one-to-one correspondence, where N is a positive integer.

According to the foregoing design, a quantity of channel layers is one more than a quantity of sacrificial layers, so that a channel layer can be exposed at an uppermost layer, which facilitates providing of more elements on the channel layer subsequently.

In a further possible design, the semiconductor device further includes an insulation layer, a second metal gate structure, and a protective layer, the insulation layer and the second metal gate structure are sequentially stacked on the uppermost channel layer, and the protective layer surrounds three side surfaces of the second metal gate structure other than the insulation layer.

According to the foregoing design, the semiconductor device may be packaged on the top, to protect an internal structure of the semiconductor device.

According to a second aspect, this application provides a fabrication method. The method includes: first alternately stacking a channel layer and a sacrificial layer; etching a peripheral part of the sacrificial layer to form a first groove; depositing a second dielectric material in the first groove to form a second dielectric region; respectively forming a source region and a drain region on two sides of the channel layer and the second dielectric region; etching a remaining part of the sacrificial layer to form a first hole, and providing a second groove in communication with the first hole in the second dielectric region; and sequentially depositing a first dielectric material and a metal gate material in the first hole to form a first dielectric region and a first metal gate structure enclosed by the first dielectric region, where the second groove is sealed by the first dielectric material to form a cavity.

In a possible design, a thickness of the sacrificial layer is less than a thickness of the channel layer.

According to the foregoing design, because two ends of the sacrificial layer are subsequently used to form second dielectric regions, a smaller thickness of the sacrificial layer results in a smaller thickness of the second dielectric region. In this way, a dielectric capacitance of the second dielectric region is reduced, and a possibility of breakdown is also lowered.

In a possible design, after the second dielectric material is deposited in the first groove, a gap exists in the formed second dielectric region, and a size of the gap is less than a size of the cavity.

According to the foregoing design, the cavity is actually generated after two phases. In the first stage, the thinner first groove is filled with the second dielectric material, so that the relatively small gap may be generated at a central position of the second dielectric region due to insufficient filling. Then, in the second phase, the relatively small gap generated in the first phase is widened to form the relatively large second groove, and the second groove is sealed by depositing the first dielectric material to form the relatively large cavity. Because the size of the cavity is relatively large, more air may exist in the cavity, so that a low dielectric constant of the air can be used to better reduce an overall dielectric constant of the second dielectric region, thereby reducing a dielectric capacitance of the second dielectric region.

In a possible design, a dielectric constant of the second dielectric material is less than a dielectric constant of the first dielectric material.

In a possible design, etching the remaining part of the sacrificial layer includes: etching all remaining parts of the sacrificial layer and adjacent channel layers, so that an etched channel layer is in a dumbbell shape or a concave shape.

In a further possible design, the first dielectric region is located above a dumbbell shaft of a dumbbell-shaped channel layer or a concave part of a concave-shaped channel layer, and the second dielectric region is located above a dumbbell end of the dumbbell-shaped channel layer or a protruding part of the concave-shaped channel layer.

In a possible design, the cavity is enclosed between the first dielectric region, the second dielectric region, and the source region; or between the first dielectric region, the second dielectric region, and the drain region.

In a possible design, alternately stacking the channel layer and the sacrificial layer includes: alternately stacking N+1 channel layers and N sacrificial layers on a substrate, where N is a positive integer.

In a further possible design, after alternately stacking the channel layer and the sacrificial layer, the method further includes: sequentially forming an insulation layer and a second metal gate structure above an uppermost channel layer; and forming a protective layer on three sides of the second metal gate structure other than the insulation layer.

According to a third aspect, this application provides an integrated circuit, including a circuit board and one or more semiconductor devices according to any one of the first aspect or the designs of the first aspect. The one or more semiconductor devices are disposed on the circuit board.

In a possible design, the one or more semiconductor devices are inserted into the circuit board.

According to a fourth aspect, this application provides an electronic device, including a housing and the integrated circuit according to any one of the third aspect or the designs of the third aspect. The integrated circuit is disposed in the housing, for example, may be packaged in the housing, to protect the integrated circuit.

For technical effects that can be achieved according to the second aspect to the fourth aspect, refer to the descriptions of beneficial effects in the first aspect. Details are not described herein again.

### BRIEF DESCRIPTION OF DRAWINGS

FIG. 1a is an example diagram of a structure of a PFET;
FIG. 1b is an example diagram of a structure of an FinFET;
FIG. 1c is an example diagram of a structure of a GAAFET;
FIG. 2 is an example diagram of a possible application scenario according to this application;
FIG. 3 is an example diagram of a partial structure of a gate-all-around semiconductor device provided in the industry;
FIG. 4 is an example diagram of a structure of a semiconductor device according to this application;
FIG. 5 is an example diagram of another structure of the semiconductor device according to this application;
FIG. 6a is an example diagram of still another structure of the semiconductor device according to this application;
FIG. 6b is an example diagram of yet another structure of the semiconductor device according to this application;
FIG. 7A to FIG. 7H are an example schematic flowchart of a fabrication method according to this application;
FIG. 8 is an example diagram of still yet another structure of the semiconductor device according to this application; and
FIG. 9 is an example diagram of a further structure of the semiconductor device according to this application.

### DESCRIPTION OF EMBODIMENTS

The following describes in detail embodiments of this application with reference to accompanying drawings.

The following explains and describes some terms in this application. It should be noted that these explanations are for ease of understanding by persons skilled in the art, and are not intended to limit the protection scope claimed by this application.

### 1. Dielectric constant and dielectric capacitance

The dielectric constant is a main parameter that reflects a dielectric property or a polarization property of a dielectric of a piezoelectric material under an action of an electrostatic field, and is usually represented by ε. When two conductors are separated by the dielectric of the piezoelectric material (referred to as a dielectric plate), a dielectric capacitance between the two conductors may be represented as the following formula (1.1): $C = \frac{ε \times A}{d} .$ (1.1)

C is the dielectric capacitance, A is an area of the dielectric plate, and d is a thickness of the dielectric plate.

The foregoing formula (1.1) may also be referred to as a capacitance law. It can be learned from the formula (1.1) that, when the area and thickness of the dielectric plate are fixed, the dielectric capacitance is positively correlated with the dielectric constant. A smaller dielectric constant indicates a smaller dielectric capacitance, and a shorter switch delay between the two conductors. Therefore, reducing the dielectric constant is an effective means to improve switching performance of a semiconductor device.

### 2. Sacrificial layer

A sacrificial layer technology is one of manufacturing process technologies of a micro-electro-mechanical system (micro-electro-mechanical system, MEMS), which is different from that of a conventional integrated circuit (integrated circuit, IC). In this technology, a thin film material that can be corroded or etched is used as an intermediate layer between a structure layer and a substrate, or between two structure layers. After the structure layer is patterned, the thin film material of the intermediate layer is removed through wet etching or dry etching, to obtain a cavity or a movable micro-structure. Because the removed intermediate layer only serves as a separation layer, it is referred to as a sacrificial layer.

### 3. Resistance law

A resistance law of a metal thin film may be expressed as the following formula (1.2): $r = \frac{ρ \times l}{s} .$ (1.2)

r is a resistance of the metal thin film, ρ is a resistivity of the metal thin film, l is a length of the metal thin film, and s is a cross-sectional area of the metal thin film.

It can be learned from the formula (1.2) that, when the resistivity and the length of the metal thin film are fixed, a larger thickness of the metal thin film indicates a larger cross-sectional area of the metal thin film and a smaller resistance of the metal thin film. In other words, the resistance of the metal thin film is negatively correlated with the thickness.

The foregoing describes some terms used in this application, and the following describes possible application scenarios of this application.

A semiconductor device provided in this application may be integrated into an integrated circuit, and the integrated circuit may be used in an electronic device. FIG. 2 is an example diagram of a possible application scenario of this application. In this application scenario, that a semiconductor device is integrated inside an electronic device is used as an example. The electronic device may include a housing, a circuit board disposed in the housing, and a semiconductor device fastened on the circuit board. Optionally, there may be a plurality of semiconductor devices, and the plurality of semiconductor devices are integrated on a same circuit board or different circuit boards, to form an integrated circuit. In addition, any semiconductor device and a circuit board may be connected in a connection manner such as bonding, and a connection between the semiconductor device and another device on the circuit board may be implemented through on-board trace, inter-board trace, or the like, to implement signal transmission between the semiconductor device and the another device on the circuit board.

For example, the electronic device may be any type of device having a processing capability, for example, a smart terminal (a mobile phone, a computer, a tablet computer, a palmtop computer, a desktop computer, a headset, a speaker, a wearable device, a vehicle-mounted device, a virtual reality device, an augmented reality device, or the like), a smart home device (for example, a television, a television set-top box, a floor sweeping robot, a smart desk lamp, a smart broadband, a sound system, a smart lighting system, an electrical appliance control system, home background music, a home theater system, an intercom system, or video surveillance), a smart manufacturing device (for example, an industrial device), a smart transportation device (for example, an unmanned vehicle, a smart vehicle, an electric vehicle, a digital vehicle, an automated guided vehicle (automated guided vehicle, AGV), an unmanned transport vehicle, a truck, a ship, an airplane, a drone, a train, a subway, or a high-speed railway), a robot (a navigation robot, an autonomous meal delivery robot, a medical robot, an industrial robot, or the like), a surveying and mapping device, or the like.

It should be understood that the foregoing application scenario is merely an example. The semiconductor device provided in this application may be further used in another possible scenario, and is not limited to the scenario in the foregoing example. For example, the semiconductor device may be further used in a telecommunication device, such as a wireless network, a fixed network, a server, or a cloud server, to improve a speed of providing a network service for a terminal device. For another example, the semiconductor device may be further used in an electronic component, such as a processor, a memory, a controller, an input/output module, and a chip module, to provide a switch function, an inverter function, a computing function, a control function, and the like. For still another example, the semiconductor device may further be used in a smart life scenario, for example, may be used in an auto-follow suitcase, or may be used in a smart dining chair, or may be used in a smart personal mobility device. Other examples are not described herein.

It should be noted that the application scenarios described in this application are intended to describe the technical solutions in this application more clearly, and do not constitute a limitation on the technical solutions provided in this application.

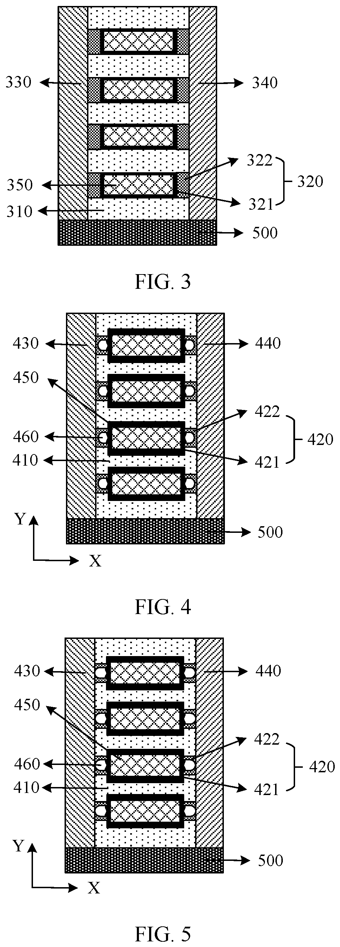

As described in the background, an existing mainstream semiconductor device gradually evolves from a tri-gate architecture to a gate-all-round architecture. For example, FIG. 3 is a diagram of a partial structure of a gate-all-around semiconductor device provided in the industry. The semiconductor device includes a channel layer 310 disposed on a substrate 500, a dielectric layer 320 disposed on the channel layer 310, a source region 330 (or 340) and a drain region 340 (or 330) disposed on two opposite sides of the channel layer 310 and the dielectric layer 320, and a metal gate structure 350. The dielectric layer 320 includes a high dielectric material region 321 and low dielectric material regions 322 disposed on two opposite sides of the high dielectric material region 321. The high dielectric material region 321 is annular, and the metal gate structure 350 is enclosed in the high dielectric material region 321. The high dielectric material region 321 is fabricated by using a high dielectric material, and is mainly used to replace a gate oxide layer, increase a thickness of gate oxygen, and suppress a gate tunneling leakage current. The low dielectric material region 322 is formed by using a low dielectric material, and the low dielectric material has a relatively small dielectric constant, so that a dielectric capacitance can be reduced, a resistor-capacitance (resistor-capacitance, RC) signal delay between the metal gate structure 350 and the source region 330/drain region 340 is reduced, and an operating frequency of the GAAFET is increased.

However, the low dielectric material has a relatively limited effect on implementing a small dielectric constant. For example, a dielectric constant of a currently most commonly-used low dielectric material such as silicon oxycarbide (SiOC) or silicon carbonitride (SiCN) is still maintained at about 3.2 to 5. The dielectric constant in this range still generates a relatively large dielectric capacitance. As a result, the semiconductor device has a limited effect on reducing the RC signal delay.

In view of this, this application provides a semiconductor device. A cavity is disposed in a low dielectric material region, so that a low dielectric constant (is approximately 1) of air in the cavity can be used to effectively reduce a dielectric capacitance in the low dielectric material region, and an RC signal delay between a metal gate structure and a source/drain region is reduced.

The following describes in detail the semiconductor device provided in this application with reference to specific accompanying drawings.

In embodiments of this application, unless otherwise stated or there is a logic conflict, terms and/or descriptions in different embodiments are consistent and may be mutually referenced, and technical features in different embodiments may be combined based on an internal logic relationship thereof, to form a new embodiment.

In addition, in this application, "greater than", "less than", and "equal to" do not mean an absolute correlation relationship, and a specific engineering error may be allowed. A "thickness value" is not an absolute value, and a specific engineering error may be allowed. In addition, descriptions of a position relationship between two devices in the accompanying drawings and the text description part do not mean an absolute position relationship, and a specific engineering error may be allowed.

FIG. 4 is a diagram of a structure of a semiconductor device according to this application. The semiconductor device may be, for example, a GAAFET. As shown in FIG. 4, the semiconductor device includes a channel layer 410, a dielectric layer 420 on the channel layer 410, a source region and a drain region 430 and 440 respectively located on two opposite sides of the channel layer 410 and the dielectric layer 420, and a first metal gate structure 450. The dielectric layer 420 includes a first dielectric region 421 and second dielectric regions 422 disposed on two opposite sides of the first dielectric region 421. The second dielectric region 422 has a cavity 460 in contact with the first dielectric region 421. The first dielectric region 421 is annular, and the first metal gate structure 450 is enclosed in the first dielectric region 421. The source region and the drain region 430 and 440 may be understood as that the source region is 430 and the drain region is 440, or the drain region is 430 and the source region is 440. The following uses the former as an example for description.

In a possible implementation, still refer to FIG. 4. The semiconductor device may specifically include N+1 channel layers 410, N dielectric layers 420, and N first metal gate structures 450; and may further include a substrate 500. The N+1 channel layers 410 and the N dielectric layers 420 are alternately stacked on the substrate 500. The N first metal gate structures 450 are enclosed in first dielectric regions 421 of the N dielectric layers 420 in a one-to-one correspondence. The source region 430 and the drain region 440 are disposed on two opposite sides of the N+1 channel layers 410 and the N dielectric layers 420. For example, the source region 430 is disposed on a left side of the N+1 channel layers 410 and the N dielectric layers 420 in the figure, and the drain region 440 is disposed on a right side of the N+1 channel layers 410 and the N dielectric layers 420 in the figure. N may be any positive integer. For example, in FIG. 4, N=4 is used as an example. However, in another example, N may also be another value. For example, in an example, N may also be 1. In this case, only two channel layers and one dielectric layer are stacked on the substrate 500, and the dielectric layer is sandwiched between the two channel layers. For another example, in another example, N may also be 2. In this case, three channel layers and two dielectric layers are stacked on the substrate 500, and the five layers are stacked in a sequence of a channel layer, a dielectric layer, a channel layer, a dielectric layer, and a channel layer. For still another example, in still another example, N may also be an integer greater than 3. Other examples are not described herein.

The following separately describes functional components and structures shown in FIG. 4, to provide an example specific implementation solution.

### 1. Dielectric layer

As described above, the dielectric layer 420 includes the first dielectric region 421 and the second dielectric region 422. The first dielectric region 421 and the second dielectric region 422 are regions formed by dielectric materials. The dielectric material may also be referred to as an insulation material, and may be used to isolate conductors that carry currents or have different potentials, so that a current can flow in a specific direction. A larger resistivity of the dielectric material indicates a larger dielectric constant and better insulation performance.

Optionally, the first dielectric region 421 is annular, which may be understood as that the first dielectric region 421 is of an end-to-end connected ring structure. The ring structure may be a rectangular ring shown in FIG. 4, or may be a circular ring, an elliptical ring, a square ring, a trapezoidal ring, a triangular ring, or another regular or irregular ring. This is not specifically limited in this application.

Optionally, a dielectric constant of the first dielectric region 421 may be greater than a dielectric constant of the second dielectric region 422. For example, the first dielectric region 421 is made of a high dielectric material, and the second dielectric region 422 is made of a low dielectric material. The high dielectric material is a material having a high dielectric constant, for example, may include but is not limited to aluminum oxide (AlO), titanium dioxide (TiO₂), an aluminum oxide-silicon nitride composite material, a ferroelectric material, polyethylene, or polystyrene. Dielectric constants of these materials are very high, and are usually greater than 10. Similarly, the low dielectric material is a material having a low dielectric constant, for example, may include but is not limited to silicon dioxide (SiO₂), silicon nitride (Si₃N₄), silicon oxycarbide (SiOC), or silicon carbonitride (SiCN). Dielectric constants of these materials are relatively low, and are usually about 3 to 5. The high dielectric material is disposed around the first metal gate structure 450, to replace a gate oxide layer, increase a thickness of the gate oxide layer, and suppress a tunneling leakage current generated by the first metal gate structure 450. The low dielectric material is disposed between the high dielectric material and the source region 430/drain region 440, so that a dielectric capacitance can be reduced by using a relatively small dielectric constant of the low dielectric material, an RC signal delay can be reduced, and an operating frequency of the semiconductor device can be increased.

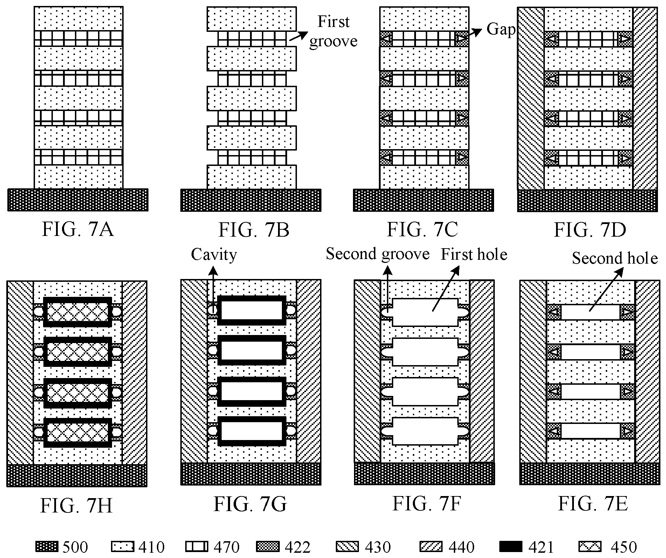

Optionally, the second dielectric region 422 has the cavity 460. The cavity 460 may be understood as a cavity structure with relatively large space. The cavity structure is not formed due to a filling process, but is a hole or groove specially provided in the second dielectric region 422, for example, a hole or groove separately provided, or a hole or groove obtained by widening a gap (for example, a gap in FIG. 7C) generated due to the filling process. A size of the cavity 460 is much larger than a size of the gap. Therefore, a low dielectric constant of more air in the large-sized cavity 460 may be used to reduce an overall dielectric capacitance of the second dielectric region 422, thereby reducing the RC signal delay between the first metal gate structure 450 and the source region 430/drain region 440.

Further, optionally, that the cavity 460 is in contact with the first dielectric region 421 may be understood that one edge of the cavity 460 is in contact with the first dielectric region 421; and the other edge of the cavity 460 may be located in the second dielectric region 422, or may be in contact with the source region 430/drain region 440. For example, FIG. 5 is a diagram of another structure of the semiconductor device according to this application. With reference to FIG. 4 and FIG. 5, the cavity 460 in FIG. 4 is enclosed between the second dielectric region 422 and the first dielectric region 421, one edge of the cavity 460 is in contact with the first dielectric region 421, and the other edge of the cavity 460 is located in the second dielectric region 422. Therefore, a length of the cavity 460 in a connection direction (an X direction shown in the figure) of the two edges is less than a length of the second dielectric region 422. However, in FIG. 5, the cavity 460 is enclosed between the second dielectric region 422, the first dielectric region 421, and the source region 430/drain region 440, and the two edges of the cavity 460 are respectively in contact with the first dielectric region 421 and the source region 430/drain region 440. Therefore, the cavity 460 penetrates the second dielectric region 422 in the X direction shown in the figure, and the length of the cavity 460 in the X direction is equal to the length of the second dielectric region 422. Based on this, if a height of the cavity 460 in a stacking direction (a Y direction shown in the figure) remains unchanged, the semiconductor device of the structure shown in FIG. 5 has a larger cavity 460. Therefore, the semiconductor device has a better effect of reducing the dielectric constant of the second dielectric region 422 than the semiconductor device of the structure shown in FIG. 4.

It should be noted that, because the cavity 460 in the second dielectric region 422 remains being in contact with the first dielectric region 421, at least a part of the RC signal of the first metal gate structure 450 is directly transmitted from the first dielectric region 421 to the cavity 460, and then directly transmitted to the source region 430/drain region 440 or transmitted to the source region 430/drain region 440 through the second dielectric region 422, regardless of whether the semiconductor device is the semiconductor device shown in FIG. 4 or the semiconductor device shown in FIG. 5. However, in a solution shown in FIG. 3, a signal is transmitted from the high dielectric material region 321 to the low dielectric material region 322 and then to the source region 430/drain region 440. It is apparent that the solution of directly transmitting the signal to the cavity 460 can accelerate a signal transmission speed at a start phase of RC signal transmission, and can effectively reduce a switch delay of the semiconductor device.

It may be understood that, in another example, the cavity 460 in the second dielectric region 422 may not be in contact with the first dielectric region 421. For example, the cavity 460 may also be entirely embedded in the second dielectric region 422; or one edge of the cavity 460 is in contact with the source region 430/drain region 440, and the other edge is in the second dielectric region 422. In this structural design, a process of forming the cavity is relatively complex, but an effect of reducing a dielectric capacitance can also be achieved.

### 2. Channel layer

For example, the channel layer 410 may be made of a conducting material. In a gate-all-around semiconductor device, the conducting material may include, for example, but is not limited to, a monocrystalline silicon nanosheet or nanowire. The nanowire can provide the best electrostatic control. The wider nanosheet can provide a larger "conduction" current, and also has better electrostatic control than a FinFET.

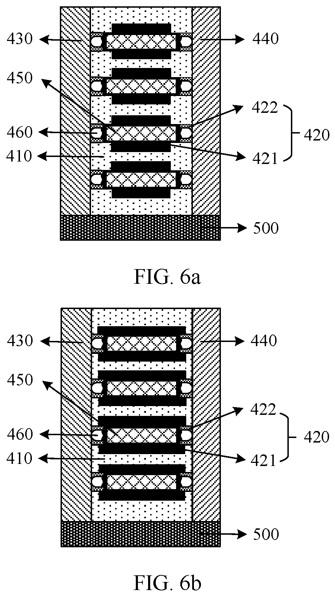

For example, still refer to FIG. 4 or FIG. 5. When the semiconductor device includes at least three channel layers 410, the channel layer 410 located in the middle may be in a dumbbell shape. In other words, the middle channel layer 410 may be of a structure that has a narrow part in the middle and wider parts on both sides. The narrow part in the middle is called a dumbbell shaft, and the wider parts on both sides are called dumbbell ends. All or a part of the first dielectric region 421 may be located above the dumbbell shaft, and all or a part of the second dielectric region 422 may be located above the dumbbell end. For example, in the structure shown in FIG. 4 or FIG. 5, the first dielectric region 421 is entirely located above the dumbbell shaft, and the second dielectric region 422 is entirely located above the dumbbell end. A semiconductor device of this structure is relatively convenient to fabricate. For another example, refer to FIG. 6a. A part of the first dielectric region 421 is located above the dumbbell shaft, and the other part is located above the dumbbell end; and the second dielectric region 422 is entirely located above the dumbbell end. Although a semiconductor device of this structure is not easy to fabricate, it may have a channel region 410 with a larger area, thereby further improving current carrying efficiency. For still another example, refer to FIG. 6b. The first dielectric region 421 is entirely located above the dumbbell shaft; and a part of the second dielectric region 422 is located above the dumbbell shaft, and a part of the second dielectric region 422 is located above the dumbbell end. Other examples are not described herein again.

Further, the structure shown in FIG. 5 is used as an example. When a voltage is applied to the first metal gate structure 450, electrons in the channel layer 410 move, so that ions in the source region 430/drain region 440 in contact with the channel layer 410 move, thereby forming a current between the first metal gate structure 450 and the source region 430/drain region 440, and implementing signal transmission between the first metal gate structure 450 and the source region 430/drain region 440. However, the signal transmission is affected by the RC signal delay, and the RC signal delay is positively correlated with a capacitance (C) of the second dielectric region 422 and a resistance (R) of the channel layer 410. A smaller capacitance C and a smaller resistance R indicate a shorter RC signal delay, faster signal transmission between the first metal gate structure 450 and the source region 430/drain region 440, and easier improvement of switching performance of the semiconductor device. Therefore, to improve the switching performance of the semiconductor device, the capacitance C of the second dielectric region 422 and the resistance R of the channel layer 410 need to be reduced.

Optionally, to reduce the capacitance C of the second dielectric region 422, a thickness of the second dielectric region 422 may be configured to be less than a thickness of a low dielectric material region of the existing semiconductor device. For example, in the existing semiconductor device shown in FIG. 3, a thickness of the low dielectric material region 322 is usually set to 15 nm. However, in the semiconductor device shown in this application, the thickness of the second dielectric region 422 may be configured to be less than 15 nm, for example, 5 nm. In this way, because it can be learned from the capacitance law formula (1.1) in the term explanation part that the capacitance of the dielectric plate is positively correlated with the thickness, a smaller thickness of the second dielectric region 422 indicates a smaller dielectric capacitance C of the second dielectric region 422, and easier reducing of the RC signal delay between the first metal gate structure 450 and the source region 430/drain region 440. In addition, a smaller thickness of the second dielectric region 422 indicates a smaller area of the second dielectric region 422, and fewer breakdown points in the second dielectric region 422. Therefore, a breakdown probability from the first metal gate structure 450 to the source region 430/drain region 440 can also be reduced.

Optionally, to reduce the resistance R of the channel layer 410, a thickness of the dumbbell end of the channel layer 410 may be configured to be greater than a thickness of a channel layer of the existing semiconductor device. For example, in the existing semiconductor device shown in FIG. 3, a thickness of the channel layer 310 is consistent with the thickness of the low dielectric material region 322, and both are 15 nm. However, in the semiconductor device shown in this application, a thickness of the dumbbell end of the channel layer 410 may be configured to be a value greater than 15 nm, for example, 20 nm or 25 nm. In this way, because it can be learned from the resistance law formula (1.2) in the term explanation part that the resistance of the metal thin film is negatively correlated with the thickness, a larger thickness of the dumbbell end of the channel layer 410 indicates a smaller resistance R of the channel layer 410, and easier reducing of the RC signal delay between the first metal gate structure 450 and the source region 430/drain region 440.

Further, optionally, the thickness of the dumbbell end of the channel layer 410 may be further configured to be greater than the thickness of the second dielectric region 422, for example, may be three times or four times the thickness of the second dielectric region 422, or even greater. For example, when the thickness of the second dielectric region 422 is 5 nm, the thickness of the dumbbell end of the channel layer 410 may be configured to 15 nm, 20 nm, or greater than 20 nm. For example, in an example, the thickness of the second dielectric region 422 may be configured to 5 nm, and the thickness of the dumbbell end of the channel layer 410 may be configured to 25 nm, so that a sum of the thickness of the second dielectric region 422 and the thickness of the dumbbell end of the channel layer 410 remains consistent with a sum of the thicknesses of the channel layer and the thickness of the low dielectric material region of the existing semiconductor device. In this way, the semiconductor device can be directly compatible with an existing chip, for example, one or more semiconductor devices on the existing chip can be directly replaced, without a need to improve a structure of the existing chip, thereby maximizing reuse. For another example, in another example, the thickness of the second dielectric region 422 may be configured to be 5 nm, and the thickness of the dumbbell end of the channel layer 410 may be configured to be between 15 nm and 25 nm. In this way, the sum of the thickness of the second dielectric region 422 and the thickness of the dumbbell end of the channel layer 410 is less than the sum of the thickness of the channel layer and the thickness of the low dielectric material region of the existing semiconductor device, so that a volume of the semiconductor device can be reduced while the RC signal delay is reduced, thereby implementing a miniaturization design of the chip.

It may be understood that the foregoing content merely provides several possible thickness configuration manners of the second dielectric region 422 and the channel layer 410 as examples. In an actual semiconductor device, the second dielectric region 422 and the channel layer 410 may also have other thickness configuration manners. For example, in still another example, the thickness of the second dielectric region 422 may also be configured to be the same as the thickness of the dumbbell end of the channel layer 410, for example, both are 15 nm, or both are 10 nm, or both are 5 nm. For example, in yet another example, the thickness of the second dielectric region 422 may be configured to be greater than the thickness of the dumbbell end of the channel layer 410. For example, the thickness of the second dielectric region 422 is 15 nm, and the thickness of the dumbbell end of the channel layer 410 is 10 nm. For example, in a further example, the thickness of the second dielectric region 422 may also be configured to be less than the thickness of the dumbbell end of the channel layer 410, but is different from the several thicknesses provided above. For example, the thickness of the second dielectric region 422 is 5 nm, and the thickness of the dumbbell end of the channel layer 410 is 15 nm; or the thickness of the second dielectric region 422 is 15 nm, and the thickness of the dumbbell end of the channel layer 410 is 20 nm; or the thickness of the second dielectric region 422 is 10 nm, and the thickness of the dumbbell end of the channel layer 410 is 12 m. Another example is not described. There are many possible thickness configuration manners, and other examples are not described herein again.

For example, still refer to FIG. 4 or FIG. 5. In addition to channel layers 410 in the middle, channel layers 410 at edges (an upper edge and a lower edge shown in the figure) may be in a concave shape. In other words, the channel layer 410 at the edge may be of a structure with protrusions on both sides and being concave in the middle. Parts protruding on both sides are referred to as protruding parts, and a part concave in the middle is referred to as a concave part. The protruding part of the channel layer 410 at the edge is similar to the dumbbell end of the channel layer 410 in the middle, and the concave part of the channel layer 410 at the edge is similar to the dumbbell shaft of the channel layer 410 in the middle. For example, all or a part of the first dielectric region 421 is located on the concave part, and all or a part of the second dielectric region 422 is located on the protruding part. For another example, a thickness of the protruding part is greater than the thickness of the channel layer of the existing semiconductor device. For still another example, the thickness of the protruding part is greater than the thickness of the second dielectric region 422, for example, may be three times or more than three times the thickness of the second dielectric region 422. Another example is not described. For related content, refer to the foregoing descriptions of the dumbbell end and the dumbbell shaft. Details are not described herein again.

It should be noted that, in this application, only the thickness of the dumbbell end of the channel layer 410 is limited, and the thickness of the dumbbell shaft of the channel layer 410 is not limited. For example, the thickness of the dumbbell shaft may be greater than the thickness of the second dielectric region 422, or may be less than the thickness of the second dielectric region 422, or may be the same as the thickness of the second dielectric region 422. This may be specifically determined according to an application scenario requirement or based on a fabrication process.

### 3. Electrode region

Herein, the electrode region of the semiconductor device is a structural region used to form an electrode, for example, may include the first metal gate structure 450, the source region 430, and the drain region 440.

Optionally, the first metal gate structure 450 is used to form a gate of the semiconductor device, and is usually made of a metal material. For example, the metal material may include but is not limited to aluminum, tungsten, molybdenum, silver, aluminum copper, and titanium aluminum alloy. There are many methods for fabricating the first metal gate structure 450. For example, a gate metal material may be first filled into a corresponding hole through a fabrication process such as physical vapor deposition, electron beam evaporation, or magnetron sputtering, and then surface planarization is performed through a chemical-mechanical polishing (chemical-mechanical polishing, CMP) process, to obtain a smooth metal gate structure.

Optionally, the source region 430 is configured to form a source of the semiconductor device, and the drain region 440 is configured to form a drain of the semiconductor device. The source region 430 may be usually made of a highly-doped silicon material, and the drain region 440 may be usually made of a lowly-doped silicon material. In this way, it can be ensured that the source region 430 can provide sufficient electrons, and the drain region 440 can absorb electrons.

In the foregoing semiconductor device, the dielectric capacitance of the second dielectric region and the resistance of the channel layer are two important parameters of an RC signal delay. The semiconductor device provided in this application uses three means to reduce the two parameters: means 1: the relatively large cavity is disposed in the second dielectric region, and the low dielectric constant of air in the cavity is used to reduce an overall dielectric constant of the second dielectric region, thereby reducing the dielectric capacitance of the second dielectric region; means 2: a relatively small thickness is disposed for the second dielectric region, and a positive correlation between a dielectric capacitance and a thickness is used to further reduce the dielectric capacitance of the second dielectric region; and means 3: a relatively large thickness is disposed for the channel layer, and a negative correlation between a resistance and a thickness is used to reduce the resistance of the channel layer. In this way, the resistance and the capacitance are reduced by combining the three means, so that the RC signal delay can be effectively reduced, and the signal transmission efficiency can be improved, thereby better improving the switching performance of the semiconductor device.

Based on the semiconductor device described above, this application may further provide a fabrication method. FIG. 7A to FIG. 7H are a possible schematic flowchart of the fabrication method. In the procedure, an example in which the semiconductor device shown in FIG. 5 is fabricated is used. The fabrication method may include the following step 1 to step 8.

Step 1: Alternately stack the channel layer 410 and a sacrificial layer 470 on the substrate 500, to obtain a structure shown in FIG. 7A.

Herein, the sacrificial layer 470 may be understood as a layered structure formed by using a sacrificial material. The sacrificial material may include but is not limited to polycrystalline silicon, photoresist, a metal film, polyimide, or the like. For example, in a specific example, the sacrificial layer 470 may be formed by using silicon germanium (SiGe).

Optionally, if it is assumed that one channel layer 410 and one sacrificial layer 470 are referred to as one group, a quantity of groups alternately stacked may be set according to a requirement. For example, when a requirement for an integration level is relatively high, a larger quantity of groups alternately stacked may be set, for example, the quantity may be greater than or equal to 4. When a requirement for low costs is relatively high, the quantity of groups alternately stacked may be set to a smaller value, for example, the quantity may be less than 4.

Further, optionally, a quantity of channel layers 410 may be one more than a quantity of sacrificial layers 470. For example, when there are N sacrificial layers 470, there may be N+1 channel layers 410, where N is a positive integer. For example, in FIG. 7A to FIG. 7H, N is 4. There are five channel layers in total, there are four sacrificial layers in total, and the five channel layers and the four sacrificial layers are alternately stacked on the substrate 500. In this way, both a bottommost layer and an uppermost layer are the channel layers 410. In this way, the channel layer 410 is exposed at the uppermost layer, so that more elements can be subsequently provided on the channel layer 410.

However, it should be understood that, in another example, the quantity of channel layers 410 may alternatively be the same as the quantity of sacrificial layers 470. For example, the channel layer 410 is a lowermost layer, and the sacrificial layer 470 is an uppermost layer; or the channel layer 410 is an uppermost layer, and the sacrificial layer 470 is a lowermost layer. Alternatively, in still another example, the quantity of sacrificial layers 470 may be greater than the quantity of channel layers 410. In this case, both the lowermost layer and the uppermost layer are the sacrificial layers 470. A value relationship between the quantity of channel layers 410 and the quantity of sacrificial layers 470 is not specifically limited in this application.

Further, optionally, a thickness of the sacrificial layer 470 may be less than a thickness of the channel layer 410. For example, the thickness of the sacrificial layer 470 is 1/3, 1/4, or less of the thickness of the channel layer 410. For example, the thickness of the sacrificial layer 470 is 5 nm, and the thickness of the channel layer is 15 nm or 20 nm. In this way, because two ends of the sacrificial layer 470 are subsequently used to form the second dielectric region 422, a smaller thickness of the sacrificial layer 470 results in a smaller thickness of the second dielectric region 422, and a smaller dielectric capacitance of the second dielectric region 422. A larger thickness of the channel layer 410 indicates a smaller resistance of the channel layer 410. The RC signal delay can be reduced by reducing the dielectric capacitance of the second dielectric region 422 and the resistance of the channel layer 410.

It should be understood that the foregoing is merely an optional implementation. In another implementation, the thickness of the sacrificial layer 470 may alternatively be greater than or equal to the thickness of the channel layer 410. This is not specifically limited in this application.

Step 2: Etch a peripheral part of the sacrificial layer 470 to form a first groove, to obtain a structure shown in FIG. 7B.

Optionally, a depth of approximately 3 nm to 6 nm may be etched inward from an outermost end of the sacrificial layer 470 according to a selective etching technology, so that the first groove is formed between the sacrificial layer 470 and two adjacent channel layers 410.

Step 3: Deposit a second dielectric material in the first groove to form the second dielectric region 422, to obtain a structure shown in FIG. 7C.

Optionally, the second dielectric material may be a low dielectric material (LowK), for example, SiOC or SiCN. Because the second dielectric region 422 is formed by using the low dielectric material, the second dielectric region 422 may also be referred to as a low dielectric material region, and the dielectric constant of the second dielectric region 422 is usually from 3.2 to 5.

Further, optionally, because the sacrificial layer 470 is relatively thin, the first groove is also relatively thin. When the relatively thin first groove is filled with the second dielectric material, generally, a triangular or triangular-like gap (which may also be referred to as a hole) is generated at a central position of the first groove due to insufficient filling, as shown in FIG. 7C. A dielectric material in the gap is air, and a dielectric constant of the air is approximately 1. Therefore, existence of the gap may reduce the overall dielectric constant of the second dielectric region 422. However, because the gap is generated due to a filling process, a size of the gap is relatively small, and the gap is basically located in a central position of the second dielectric region, the gap has a relatively limited effect on reducing the dielectric constant.

Step 4: Form the source region 430 and the drain region 440 on two sides of the channel layer 410 and the second dielectric region 422 respectively, to obtain a structure shown in FIG. 7D.

For example, a monocrystalline silicon material may be first deposited on a left side of the channel layer 410 and the second dielectric region 422 shown in the figure, and then high-concentration ions of are doped in the monocrystalline silicon material, to form the source region 430. Similarly, a monocrystalline silicon material may be first deposited on a right side of the channel layer 410 and the second dielectric region 422 shown in the figure, and then low-concentration ions are doped in the monocrystalline silicon material, to form the drain region 440.

Step 5: Etch a remaining part of the sacrificial layer 470 to form a second hole, to obtain a structure shown in FIG. 7E.

Herein, the second hole is obtained by etching the sacrificial layer 470. Therefore, a height of the second hole is the same as the thickness of the sacrificial layer 470.

Step 6: Etch channel layers 410 around the second hole, widen the second hole to a first hole, and provide, in the second dielectric region 422, a second groove in communication with the first hole, to obtain a structure shown in FIG. 7F.

Herein, the first hole is obtained by widening the second hole, so that a height of the first hole is greater than the thickness of the sacrificial layer 470.

Optionally, because the second hole is located on a center position of the channel layer 410, etching the channel layer 410 around the second hole thins a center area of the channel layer 410. In this way, a channel layer 410 located in the middle is presented in a dumbbell shape, and a channel layer 410 located at the edge is presented in a concave structure. A dumbbell end of the dumbbell-shaped channel layer and a protruding part of the concave-shaped channel layer are located below the second dielectric region 422, and a dumbbell shaft of the dumbbell-shaped channel layer and a concave part of the concave-shaped channel layer are located below the widened first hole.

Optionally, the second groove may be obtained by widening the gap in the second dielectric region 422. For example, after the first hole is obtained through widening, the second dielectric material may be first selectively etched at central positions on two sides of the first hole, until the second dielectric material is etched to a position of the gap; and then selective etching continues to be performed on the second dielectric material around the gap, to widen the gap, to obtain the second groove with a relatively large size.

Further, optionally, if time for etching the second dielectric material is relatively short, and an edge of the second dielectric region 422 is not etched, one edge of the second groove is in communication with the first hole, and the other edge is located in the second dielectric region 422, so that the second groove is enclosed by the second dielectric region 422 and the first hole. On the contrary, if the time for etching the second dielectric material is relatively long, and the edge of the second dielectric region 422 has been etched, one edge of the second groove is in communication with the first hole, and the other edge is in contact with the source region 430/drain region 440, so that the second groove is enclosed by the second dielectric region 422, the source region 430/drain region 440, and the first hole. A size of the second groove formed by the latter is larger, more air exists in the second groove, and an effect of reducing the dielectric constant is better. However, more etching materials are required, resulting in larger fabrication costs. Therefore, if a requirement for a low dielectric constant is relatively high, more etching materials may be used for etching to obtain a relatively large cavity. If a requirement for low fabrication costs is relatively high, a slightly less etching material may be used to obtain a slightly smaller cavity through etching; and the cavity is still much larger than the gap in step 3, so that the dielectric constant can also be partially reduced.

Step 7: Deposit a first dielectric material in a circumferential direction of the first hole to form an annular first dielectric region 421, and seal the second groove by using the first dielectric material to form a cavity, to obtain a structure shown in FIG. 7G.

Optionally, the first dielectric material may be a high dielectric material (HighK), for example, AlO or TiO₂. Because the first dielectric region 421 is formed by using the high dielectric material, the first dielectric region 421 may also be referred to as a high dielectric material region, and the dielectric constant of the first dielectric region 421 is usually greater than 10.

Further, optionally, because the first hole is in communication with the second groove, when the first dielectric material is deposited in the circumferential direction of the first hole, a part of the first dielectric material is also deposited at a position at which the second groove is in communication with the first hole, so that the second groove is sealed to form the cavity. Because a size of the second groove is relatively large, a size of the cavity is also relatively large. Compared with the gap formed due to the filling process in step 3, the cavity is much larger. In other words, the cavity may include a larger volume of air, and the low dielectric constant of the larger volume of air may be used to better reduce the overall dielectric constant of the second dielectric region 422, thereby reducing the dielectric capacitance of the second dielectric region 422.

Step 8: Deposit a metal gate material in the first dielectric region 421 to form the first metal gate structure 450, to obtain a structure shown in FIG. 7H.

Herein, the first metal gate structure 450 is enclosed by the first dielectric region 421. Therefore, the first dielectric region 421 may be used to isolate the first metal gate structure 450 from the channel layer 410. In addition, electrons in the channel layer 410 are allowed to approach or move away from the first metal gate structure 450 with a voltage applied to the first metal gate structure 450, to implement conduction or disconnection between the first metal gate structure 450 and the source region 430/drain region 440.

According to the foregoing fabrication method, the cavity in the second dielectric region is actually formed through two phases. A first phase is formed in a filling phase of the second dielectric region, and a second phase is formed in an etching phase of the channel layer and a deposition phase of the first dielectric region. In the first phase, an etching groove (namely, the first groove) of the thin sacrificial layer is filled with the second dielectric material, so that the small gap is generated at the central position of the second dielectric region due to insufficient filling. Then, in the second phase, the gap in the first phase is widened in a process of etching the channel layer, to widen the gap into the relatively large second groove, and the second groove is sealed by depositing the first dielectric material, to form the relatively large cavity. Because the size of the cavity is relatively large, more air may exist in the cavity, so that the low dielectric constant of the air can be used to better reduce the overall dielectric constant of the second dielectric region, thereby reducing the dielectric capacitance of the second dielectric region.

The foregoing content describes a specific structure of the semiconductor device provided in this application and the corresponding fabrication method. However, it should be understood that the structure and the fabrication method are merely examples, an actual semiconductor device may further include more or fewer layers or structures, and an actual fabrication method may further include more or fewer steps. This is not specifically limited in this application.

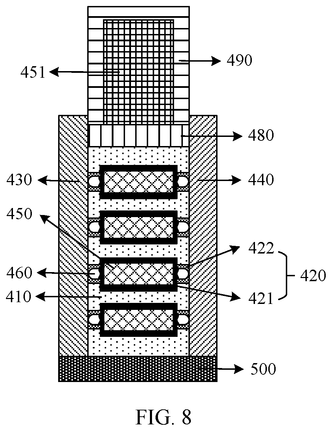

For example, FIG. 8 is a diagram of still another possible structure of the semiconductor device according to this application. The semiconductor device shown in FIG. 5 is used as an example in the figure, and the structure shown in FIG. 8 may be understood as a structure obtained after an uppermost channel layer of the semiconductor device shown in FIG. 5 is packaged. As shown in FIG. 8, in addition to the channel layer 410, the dielectric layer 420, the source region 430, the drain region 440, and the first metal gate structure 450, the semiconductor device in this example may further include an insulation layer 480, a second metal gate structure 451, and a protective layer 490. The insulation layer 480 is located on the uppermost channel layer 410, the second metal gate structure 451 is located on the insulation layer 480, and the protective layer 490 surrounds three side surfaces of the second metal gate structure 451 other than the insulation layer 480, for example, a left side surface, an upper side surface, and a right side surface shown in the figure.

Optionally, the second metal gate structure 451 may also be configured to form the gate of the semiconductor device, and may be usually made of a metal material. For example, the metal material may include but is not limited to aluminum, tungsten, molybdenum, silver, aluminum copper, and titanium aluminum alloy.

Optionally, the protective layer 490 may also be referred to as a barrier layer or a mask, and may be configured to protect the second metal gate structure 451 located inside, to prevent the second metal gate structure 451 from being affected by an external environment. The protective layer 490 may be made of a plurality of materials, for example, may include but is not limited to a metal material such as titanium, tantalum, chromium, aluminum, or copper; or a non-metal material such as barium fluoride or calcium fluoride; or a composite material of metal and non-metal.

Optionally, the insulation layer 480 may be configured to isolate the second metal gate structure 451 from the lower channel layer 410. A function of the insulation layer 480 is similar to that of the first dielectric region 421. For example, when a voltage is applied to the second metal gate structure 451, the voltage drives electrons in the lower channel layer 410 to move, so that electrons in the source region 430/drain region 440, due to isolation of the insulation layer 480, gather on an upper surface of the channel layer via the channel layer 410; or the electrons in the channel layer 410 are dispersed to the source region 430/drain region 440, and conduction between the second metal gate structure 451 and the source region 430/drain region 440 is implemented.

Further, optionally, the insulation layer 480 may be formed by using a metal oxide, for example, may include but is not limited to aluminum oxide (Al₂O₃), ferric oxide (Fe₂O₃), sodium oxide (Na₂O), magnesium oxide (MgO), potassium oxide (K₂O), and the like.

It may be understood that, if the semiconductor device shown in FIG. 8 needs to be fabricated, in step 1 shown in FIG. 7A, after the channel layer 410 and the sacrificial layer 470 are alternately stacked on the substrate 500, the insulation layer 480 may continue to be deposited on the uppermost channel layer 410, the second metal gate structure 451 may be deposited on the insulation layer 480, and a mask is deposited on a periphery of the second metal gate structure 451 to obtain the protective layer 490. Then, the subsequent steps 2 to 8 are performed based on the structure, to obtain the semiconductor device shown in FIG. 8.

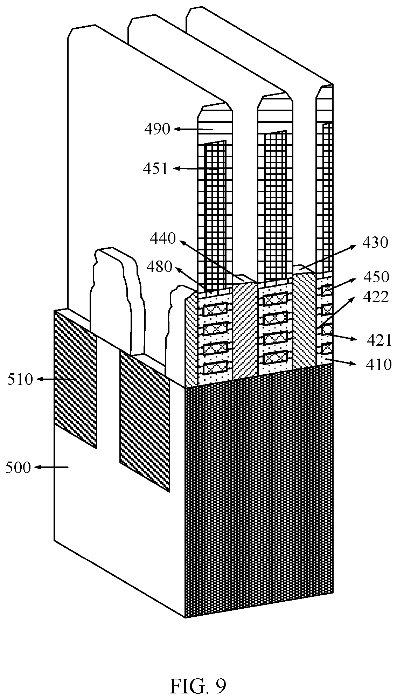

In addition, FIG. 8 illustrates a case in which only one row and one column of the semiconductor device are fabricated on one substrate. To improve integration density of semiconductor devices, semiconductor devices with a plurality of rows and a plurality of columns may also be fabricated on one substrate at the same time. For example, FIG. 9 is a diagram of yet another structure of the semiconductor device according to this application. In the structure, at least three columns of semiconductor devices are fabricated on one substrate 500, and each column has at least two rows. Semiconductor devices in adjacent rows may be separated by using the isolation layer 510, to reduce mutual interference between the semiconductor devices in the adjacent rows. Semiconductor devices in adjacent columns may share a same source region 430 or drain region 440. For example, from left to right, a semiconductor device in the first column and a semiconductor device in the second column share a same drain region 440, and the semiconductor device in the second column and a semiconductor device in the third column share a same source region 430. A manner of sharing a source region or a drain region can reduce fabrication difficulty, and can further improve integration.

It should be noted that, for concepts, explanations, detailed descriptions, and other steps in the semiconductor device shown in FIG. 8 or FIG. 9, refer to the descriptions of the content in the foregoing structure and method embodiments. Details are not described herein again.

Based on the semiconductor device described above, this application may further provide an integrated circuit. The integrated circuit may include a circuit board and one or more semiconductor devices disposed on the circuit board. The semiconductor device may be the semiconductor device in any one of the foregoing embodiments, for example, the semiconductor device shown in FIG. 4, FIG. 5, FIG. 6a, FIG. 6b, FIG. 8, or FIG. 9.

Based on the integrated circuit described above, this application may further provide an electronic device. Refer to FIG. 2. The electronic device may include the housing and the foregoing integrated circuit, and the integrated circuit is disposed in the housing. For example, the circuit board in the integrated circuit may be fastened to an inner wall on one side of the housing, and the semiconductor device on the circuit board faces an inner wall on the other side of the housing, so that the integrated circuit is packaged in the housing as a whole, to protect the integrated circuit.

In the foregoing descriptions of this application, "a plurality of" means two or more. "/" means "or". For example, "A/B" means A or B. The word "optionally" or "example" is used to represent giving an example, an illustration, or a description. Any embodiment or design solution described as an "example" or "optional" in this application shall not be construed as being more preferred or more advantageous than another embodiment or design solution. Alternatively, it may be understood as that the word "example" or "optional" is used to present a concept in a specific manner, and does not constitute a limitation on this application.

In addition, various numbers in this application are merely used for differentiation for ease of description, and are not used to limit the scope of this application. For example, the terms "first", "second", "third" and the like are intended to distinguish between similar objects, but do not necessarily indicate a specific order or sequence. In addition, the terms "include", "have", and any variant thereof are intended to cover non-exclusive inclusion, for example, include a series of steps or units. Methods, products, or devices are not necessarily limited to those steps or units expressly listed, but may include other steps or units not expressly listed or inherent to such processes, methods, products, or devices.

In addition, the foregoing content is merely a possible embodiment provided in this application. The structure or method in this embodiment may also be extended to any device or component that has a requirement on a dielectric capacitance. In addition, with evolution of a system architecture and emergence of a new scenario, the structure or method provided in this application is also applicable to a similar technical problem. This is not specifically limited in this application.

Clearly, persons skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A semiconductor device, comprising a channel layer, a dielectric layer above the channel layer, a source region and a drain region respectively located on two opposite sides of the channel layer and the dielectric layer, and a first metal gate structure, wherein
the dielectric layer comprises an annular first dielectric region and second dielectric regions respectively located on two opposite sides of the first dielectric region, the second dielectric region comprises a cavity in contact with the first dielectric region, and the first metal gate structure is enclosed in the first dielectric region.

2. The semiconductor device according to claim 1, wherein a dielectric constant of the first dielectric region is higher than a dielectric constant of the second dielectric region.

3. The semiconductor device according to claim 1 or 2, wherein the channel layer is in a dumbbell shape or a concave shape.

4. The semiconductor device according to claim 3, wherein a thickness of the second dielectric region is less than a thickness of a dumbbell end of a dumbbell-shaped channel layer, or less than a thickness of a protruding part of a concave-shaped channel layer.

5. The semiconductor device according to claim 3 or 4, wherein the first dielectric region is located above a dumbbell shaft of the dumbbell-shaped channel layer or a concave part of the concave-shaped channel layer, and the second dielectric region is located above the dumbbell end of the dumbbell-shaped channel layer or the protruding part of the concave-shaped channel layer.

6. The semiconductor device according to any one of claims 1 to 5, wherein the cavity is enclosed between the first dielectric region, the second dielectric region, and the source region; or is enclosed between the first dielectric region, the second dielectric region, and the drain region.

7. The semiconductor device according to any one of claims 1 to 6, wherein the semiconductor device comprises a substrate, N+1 channel layers, N dielectric layers, and N first metal gate structures, the N+1 channel layers and the N dielectric layers are alternately stacked on the substrate, and the N first metal gate structures are enclosed in first dielectric regions of the N dielectric layers in a one-to-one correspondence, wherein N is a positive integer.

8. The semiconductor device according to claim 7, further comprising an insulation layer, a second metal gate structure, and a protective layer, wherein
the insulation layer and the second metal gate structure are sequentially stacked on an uppermost channel layer, and the protective layer surrounds three side surfaces of the second metal gate structure other than the insulation layer.

9. A fabrication method, wherein the method comprises:
alternately stacking a channel layer and a sacrificial layer;
etching a peripheral part of the sacrificial layer to form a first groove;
depositing a second dielectric material in the first groove to form a second dielectric region;
separately forming a source region and a drain region on two sides of the channel layer and the second dielectric region;
etching a remaining part of the sacrificial layer to form a first hole, and providing a second groove in communication with the first hole in the second dielectric region; and
sequentially depositing a first dielectric material and a metal gate material in the first hole to form a first dielectric region and a first metal gate structure enclosed by the first dielectric region, wherein the second groove is sealed by the first dielectric material to form a cavity.

10. The method according to claim 9, wherein a thickness of the sacrificial layer is less than a thickness of the channel layer.

11. The method according to claim 9 or 10, wherein after the second dielectric material is deposited in the first groove, a gap exists in the formed second dielectric region, and a size of the gap is less than a size of the cavity.

12. The method according to any one of claims 9 to 11, wherein a dielectric constant of the second dielectric material is less than a dielectric constant of the first dielectric material.

13. The method according to any one of claims 9 to 12, wherein etching the remaining part of the sacrificial layer comprises:
etching all remaining parts of the sacrificial layer and adjacent channel layers, so that an etched channel layer is in a dumbbell shape or a concave shape.

14. The method according to claim 13, wherein the first dielectric region is located above a dumbbell shaft of a dumbbell-shaped channel layer or a concave part of a concave-shaped channel layer, and the second dielectric region is located above a dumbbell end of the dumbbell-shaped channel layer or a protruding part of the concave-shaped channel layer.

15. The method according to any one of claims 9 to 14, wherein the cavity is enclosed between the first dielectric region, the second dielectric region, and the source region; or is enclosed between the first dielectric region, the second dielectric region, and the drain region.

16. The method according to any one of claims 9 to 15, wherein alternately stacking the channel layer and the sacrificial layer comprises:
alternately stacking N+1 channel layers and N sacrificial layers on a substrate, wherein N is a positive integer.

17. The method according to claim 16, wherein after alternately stacking the channel layer and the sacrificial layer, the method further comprises:
sequentially forming an insulation layer and a second metal gate structure above an uppermost channel layer; and
forming a protective layer on three sides of the second metal gate structure other than the insulation layer.

18. An integrated circuit, comprising a circuit board and one or more semiconductor devices according to any one of claims 1 to 8, wherein the one or more semiconductor devices are disposed on the circuit board.

19. An electronic device, comprising a housing and the integrated circuit according to claim 18, wherein the integrated circuit is disposed in the housing.
